# EUROPÄISCHE PATENTSCHRIFT

(11) **EP 1 245 298 B1**
(45) Veröffentlichungstag und Bekanntmachung des Hinweises auf die Patenterteilung: **27.02.2008**
(21) Anmeldenummer: 01107967.0
(22) Anmeldetag: 29.03.2001
(51) Int. Cl.: B05D 7/24, B05D 7/02, B05D 7/00

(54) **Verfahren zum Herstellen eines beschichteten Kunststoffkörpers**
Process for the production of coated plastic articles
Procédé de fabrication de pièces en plastiques revêtues

(43) Veröffentlichungstag der Anmeldung: 02.10.2002
(73) Patentinhaber: Schott AG, 55122 Mainz (DE)
(72) Erfinder: Kuhr, Markus, Dr., 55579 Wöllstein (DE); Wolff, Detlef, Dr., 55124 Mainz (DE); Walther, Marten, Dr., 55270 Engelstadt (DE); Behle, Stephan, Dr., 55278 Hahnheim (DE); Bauer, Stefan, Dr., 55286 Wörrstadt (DE); Klippe, Lutz, Dr., 65187 Wiesbaden (DE)
(74) Vertreter: Blumbach - Zinngrebe

(56) Entgegenhaltungen:
- EP-A- 0 285 870
- EP-A- 0 752 483
- EP-A- 0 801 146
- EP-A- 0 839 928
- WO-A-01/07678
- DE-A- 19 523 444
- DE-A- 19 740 806
- US-A- 5 900 285

## Beschreibung

Die Erfindung betrifft das Beschichten eines Substrates aus einem organischen Kunststoff zum Erzeugen eines beschichteten Körpers. Dabei handelt es sich um Körper jeglicher Art und Gestalt. In Betracht kommen insbesondere gekrümmte Körper oder leicht gekrümmte Körper, beispielsweise Brillengläser. Ferner kommen flache oder annähernd flache Körper wie Display-Abdeckscheiben in Betracht, z. B. bei Mobilfunkgeräten, Telefon-Feststationen, usw. Bei dem genannten Kunststoff handelt es sich z. B. um Polymethylmetakrylat (PMMA) sowie dessen Derivate oder mit diesem wesensgleiche Kunststoffe. PMMA hat sich bei den verschiedenen Anwendungsgebieten sehr bewährt und ist kostengünstig.

Die Beschichtung ist eine Mehrfachbeschichtung. Die einzelnen Schichten sind optische Funktionsschichten wie zum Beispiel eine Anti-Reflex-Schicht, aber auch Schichten mit besonderen mechanischen Eigenschaften wie beispielsweise eine hydrophobe Deckschicht, die sogenannte Reinigungsschicht, die sich mechanisch leicht reinigen läßt. Zwischen den Funktionsschichten und dem Substrat wird im allgemeinen eine sogenannte Haftvermittler-Antikratz-Schicht aufgebracht, hier ganz allgemein "Zwischenschicht" genannt. Dieser kommt entscheidende Bedeutung für die Brauchbarkeit des ganzen Produktes zu. Sie ist nämlich für die Haftung des gesamten Schichtpaketes am Substrat verantwortlich. Die Zwischenschicht kann eine einzige homogene Schicht sein. Sie kann auch eine Mehrlagenschicht sein. Dabei bilden die einzelnen Schichten einen Gradienten, ausgehend von einer Schicht, die unmittelbar auf das Substrat folgt und diesem als Organikum wesensgleich oder ähnlich ist, bis zu einer Schicht, die der nächstfolgenden Funktionsschicht nahe ist und die dieser als Anorganikum wesensgleich oder ähnlich ist.

Es sind zahlreiche Verfahren zum Herstellen von Gegenständen der genannten Art bekannt, das heißt von Kunststoffsubstraten mit hierauf befindlichen Schichten. Ein solches Verfahren ist in DE 195 23 444 A1 beschrieben. Dabei wird ein Kunststoff mittels eines plasmaunterstützten CVD-Verfahrens (PECVD-Verfahren) durch eine elektrische Hochfrequenzentladung bei vermindertem Gasdruck mit einer Schutzschicht versehen. Dabei geht es um das Erzielen einer möglichst hohen Zähigkeit dieser Schicht zur Vermeidung der Versprödung.

DE 197 03 538 A1 beschreibt ein Verfahren zum Modifizieren von Oberflächen von PMMA-Substraten. Hierbei wird die Substrat-Oberfläche mit einer schützenden Schicht versehen. Damit soll sich eine verbesserte Haftung für nachfolgend aufzubringende Funktionsschichten erreichen lassen. Das Aufbringen der genannten Schutzschicht stellt einen zusätzlichen Verfahrensschritt dar und bedeutet somit zusätzlichen Aufwand und Kosten.

Weitere Verfahren zum Aufbringen dünner Schichten auf Kunststoff-Substrate sind beschrieben in DE 34 13 019 A1, EP 0 422 323 A1, DE 40 04 116 A1 und anderen. Dabei geht es unter anderem auch um die Haftung der Schicht, die auf das Substrat aufgebracht wird, und zwar mittels des CVD- oder PECVD-Verfahrens. DE 100 10 766 zeigt und beschreibt ein Verfahren und eine Vorrichtung zur Beschichtung von insbesondere gekrümmten Substraten, beispielsweise von Brillengläsern.

Die WO 01/07678 zeigt ein Plasma-CVD-Verfahren, bei welchem die Substrattemperatur unter 50° C gehalten wird. Die DE 19740806 zeigt eine mittels eines PICVD-Verfahrens beschichtete Mikrotiterplatte aus PMMA.

Die bisher angewandten Verfahren haben nicht befriedigt. Dabei wurde nicht die notwendige Haftfestigkeit erzielt. Vielmehr besteht bei derart hergestellten Gegenständen die Gefahr des Lösens der genannten Zwischenschicht, und damit des gesamten Schichtpaketes. Dies kann dazu führen, daß der Gegenstand vorzeitig unbrauchbar wird.

Der Erfindung liegt die Aufgabe zugrunde, ein Verfahren sowie eine Vorrichtung anzugeben, womit ein Substrat aus Kunststoff, insbesondere aus Polymethylmetakrylat (PMMA) mit einer Zwischenschicht, der sogenannten Haftvermittler-Antikratz-Schicht, sowie Funktionsschichten beschichtet werden kann, bei zuverlässigem Anhaften der Zwischenschicht am Substrat und natürlich auch der einzelnen Schichten untereinander, so daß ein Ablösen ausgeschlossen ist. Verfahren und Vorrichtung sollen kostengünstig sein. Hiermit soll es ermöglicht werden, klimabeständige und/oder UV-beständige Produkte zu erzeugen. Außerdem soll durch die Erfindung ein entsprechendes Produkt angegeben werden, das sich durch eine zuverlässige Haftung zwischen Substrat, Zwischenschicht und Funktionsschichten auszeichnet, das sich kostengünstig herstellen läßt und das gegebenenfalls klimabeständig und UV-beständig ist.

Diese Aufgabe wird durch die Merkmale des unabhängigen Anspruches 1 gelöst.

Die Erfinder haben folgendes erkannt: Bei den bisher angewandten PECVD-Verfahren zum Aufbringen von Schichten auf einem Substrat wird das Interface des Substrates durch die damit verbundene Energiebelastung gestört oder in seiner Struktur zerstört. Dies hat eine Verringerung der Haftfähigkeit zwischen Substrat und angrenzender Schicht zur Folge. Demgemäß haben die Erfinder erkannt, daß die Energiebelastung, die mit der Plasmaentladung verbunden ist, minimiert werden muß, um die Haftung zu steigern. Dabei geht es sowohl um das Maß der aufgebrachten Energie als auch um die Art und Weise ihres Aufbringens. Der zulässige Grenzwert der Belastung zum Erzielen einer in der Praxis ausreichenden Haftung läßt sich durch den Versuch ermitteln.

Die beiden wesentlichen Wege zum Anwenden dieser Erkenntnis sind die folgenden:

Zum einen läßt sich die Energiebelastung dadurch in Grenzen halten, daß die Plasmaanwendung in gepulster Weise geschieht, das heißt zum Beispiel periodisch und somit in stets gleichbleibenden Intervallen, oder intermittierend, wobei die Intervalle nicht gleichbleibend sein müssen. Dieses Verfahren wurde von der Anmelderin eingeführt und als "PICVD" Verfahren bezeichnet. Wesentlich hierbei ist die erwähnte gepulste Betriebsweise. Hierdurch wird die Energiebelastung verringert, und gleichzeitig bleibt die Verankerungswirkung, welche die Plasmabehandlung zur Folge hat, erhalten.

Zum anderen läßt sich der genannte Grundgedanke der Erfindung-Verringerung der Energiebelastung des Interface- oder des Grenzbereiches des Substrates, insbesondere durch Anwenden einer hohen Beschichtungsrate beim PECVD-Verfahrensschritt verwirklichen. Dies bedeutet, daß man die Schicht schnell anwachsen läßt, somit möglichst viel Schichtsubstanz in einer möglichst kurzen Zeitspanne aufbringt.

Mit der Erfindung ist es somit möglich, Polymere und Copolymere sowie deren Derivate von Acrylsäure und deren Derivate einschließlich Polynitril oder wesensgleiche Kunststoffe mit einem Schichtpaket zu belegen, das schwer beschichtbare PMMA sowie dessen Derivate oder wesensgleiche Kunststoffe bei höchster Zuverlässigkeit des Haftens. Damit lassen sich dünne, hochwertige Schichten im Mikrometer- oder Submikrometerbereich zuverlässig an das Substrat binden. Das Verfahren und die Vorrichtung zu dessen Durchführung sind besonders kostengünstig, weil die gesamte Beschichtung in ein und derselben Einrichtung aufgebracht werden kann. Praktische Versuche haben ergeben, daß die Schichten eine Prüfung der Haftfestigkeit mit dem Klebeband nach DIN 58 196, Teil 6, standhalten.

Ein weiterer wichtiger Vorteil sind die Klimabeständigkeit und die UV-Beständigkeit. Diese sind grundsätzlich erzielbar. So bestehen die Schichten Klimatests, die nach ISO 9022-2 durchgeführt werden.

Die Erfindung ist bei jeglicher Art von Beschichtung anwendbar. Die Schichteigenschaften lassen sich durch die eingesetzten Rohstoffe sowie durch die Betriebsparameter der Anlage steuern. Die Schichteigenschaften lassen sich in weiten Grenzen verändern. Die Zwischenschicht wird im allgemeinen eine sogenannte Gradientenschicht sein, die aus mehreren Schichten zusammengesetzt ist, und bei der die substratnahe Schicht dem Substrat wesensgleich ist, und die substratferne Schicht den Funktionsschichten wesensgleich ist.

Die Erfindung läßt sich auch anwenden bei Verwendung des sogenannten Remote-PECVD-Verfahrens bzw. des Remote-PICVD-Verfahrens. Hierbei sind bekanntlich Plasmaraum und Beschichtungsraum voneinander getrennt. Aus dem Plasmaraum werden angeregte Species in den Beschichtungsraum geleitet.

Auch ist eine Kombination der beiden genannten Wege möglich. So kann man das Energieniveau bei der Plasma-Anwendung auf einem geringen Wert halten, dabei gleichzeitig aber gleichwohl Plasma in gepulster Weise anwenden.

Die Erfindung ist anhand der Zeichnung näher erläutert. Darin ist im einzelnen folgendes dargestellt:
Figur 1 veranschaulicht in einer perspektivischen Schnittdarstellung einen erfindungsgemäßen Körper.
Figur 2 zeigt in schematischer Darstellung eine Vorrichtung zum Beschichten eines Substrates.

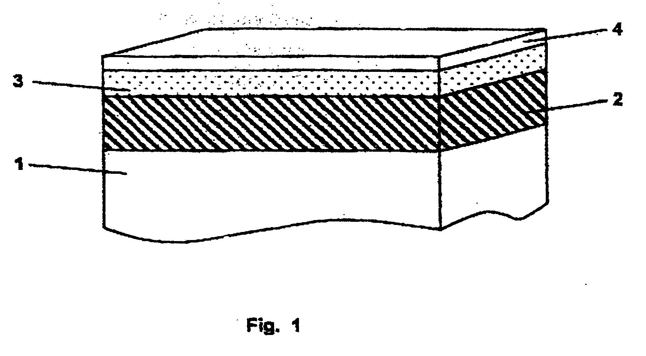

In Figur 1 erkennt man ein Substrat 1. Auf dieses ist eine Zwischenschicht 2 aufgebracht. Diese hat eine Haftvermittler - Antikratz-Funktion. Sie ist zuverlässig am Substrat verankert, weil sie erfindungsgemäß bei minimaler Energiebelastung auf das Substrat aufgebracht wurde.

Die Zwischenschicht 2 kann eine sogenannte Gradientenschicht sein, aufgebaut aus mehreren Einzelschichten unterschiedlicher Zusammensetzung. Dabei ist die substratnahe Einzelschicht dem Substrat 1 wesensgleich, während die obere, substratferne Schicht einer nachfolgenden Schicht wesensgleich ist.

Die nachfolgende Schicht ist die Funktionsschicht 3. Diese übt beispielsweise optische Funktionen aus.

Den Abschluß bildet eine Deckschicht 4.

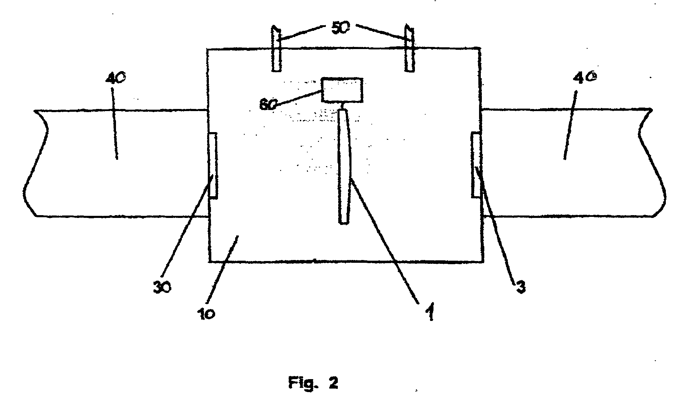

Die in Figur 2 gezeigte Vorrichtung weist die folgenden Komponenten auf:
ein Beschichtungsreaktor 10 trägt das Substrat 1. Man erkennt ein Mikrowellenfenster 30, einen Mikrowellenhohlleiter 40, einen Gaseinlaß 50 sowie einen Substrathalter 60.

### Bezugszeichenliste

- 1: Substrat
- 2: Zwischenschicht
- 3: Funktionsschicht
- 4: Deckschicht
- 10: Beschichtungsreaktor
- 30: Mikrowellenfenster
- 40: Mikrowellenhohlleiter
- 50: Gaseinlaß
- 60: Substrathalter

## Patentansprüche

1. Verfahren zum Beschichten eines Substrates aus einem organischen Kunststoff, insbesondere aus Polymethylmetakrylat (PMMA) oder einem Derivat hiervon oder einem mit diesem wesensgleichen Kunststoff, mit einer Mehrzahl von Funktionsschichten sowie mit einer zwischen diesen beiden befindlichen Zwischenschicht,
**dadurch gekennzeichnet, dass**
die Zwischenschicht auf das Substrat mittels eines PICVD-Verfahrens aufgebracht wird,
wobei die Gesamtdauer der Plasmaeinwirkung wenigstens ein Tausendstel der einwirkungsfreien Zeitspanne zwischen zwei Plasmaimpulsen beträgt, und höchstens gleich dieser ist.

2. Verfahren nach Anspruch 1, **dadurch gekennzeichnet, daß** der Einwirkungsimpuls der Plasmabeaufschlagung zwischen 0,1 und 10 ms, vorzugsweise zwischen 0,5 und 5 ms dauert.

3. Verfahren nach einem der Ansprüche 1 oder 2, **dadurch gekennzeichnet, daß** die Beschichtungsrate bei der Plasma-Einwirkung pro Zeiteinheit und pro Flächeneinheit > 10 Nanometer/min ist, vorzugsweise > 100 Nanometer/min.

## Claims

1. Method for coating a substrate made of an organic synthetic material, especially polymethyl methacrylate (PMMA) or a derivative thereof or a synthetic material of the same nature, with a plurality of functional layers and also with an intermediate layer between these two,
**characterised in that** the intermediate layer is applied to the substrate by means of a PICVD process,
whereby the total duration of the plasma effect is at least a thousandth of the effect-free time period between two plasma impulses and is at most equal to it.

2. Method according to claim 1, **characterised in that** the effective impulse of the plasma application lasts between 0.1 and 10 ms, preferably between 0.5 and 5 ms.

3. Method according to one of the claims 1 or 2, **characterised in that** the coating rate during the plasma effect per time unit and per surface unit > 10 nanometres/min, preferably > 100 nanometres/min.

## Revendications

1. Procédé de revêtement d'un substrat en une matière plastique organique, notamment en polyméthacrylate de méthyle (PMMA) ou un dérivé de celui-ci ou en une matière plastique de nature analogue à celui-ci, comportant une pluralité de couches fonctionnelles, ainsi qu'une couche intermédiaire située entre ces deux couches,
**caractérisé en ce que**
la couche intermédiaire est appliquée sur le substrat au moyen d'un procédé PICVD,
la durée totale de l'action du plasma étant d'au moins un millième de l'intervalle de temps sans action entre deux impulsions de plasma et au maximum égale à celui-ci.

2. Procédé selon la revendication 1, **caractérisé en ce que** la durée de l'impulsion d'action de l'alimentation en plasma est comprise entre 0,1 et 10 ms, de préférence entre 0,5 et 5 ms.

3. Procédé selon l'une des revendications 1 ou 2, **caractérisé en ce que** le taux de revêtement par unité de temps et par unité de surface sous l'effet du plasma est > 10 nanomètres/min, de préférence > 100 nanomètres/min.
